# EUROPÄISCHE PATENTSCHRIFT

(11) **EP 4 054 899 B1**
(45) Veröffentlichungstag und Bekanntmachung des Hinweises auf die Patenterteilung: **06.12.2023**
(21) Anmeldenummer: 20764056.6
(22) Anmeldetag: 25.08.2020
(51) Int. Cl.: B60R 16/033, F02N 11/00, H02J 7/00, B60L 58/16, G01R 31/392

(54) **VERFAHREN UND SYSTEM ZUM VORHERSAGEN EINER MOTORSTART-PERFORMANCE EINES ELEKTRISCHEN ENERGIESPEICHERSYSTEMS**
METHOD AND SYSTEM FOR PREDICTING ENGINE-START PERFORMANCE OF AN ELECTRICAL ENERGY STORAGE SYSTEM
PROCÉDÉ ET SYSTÈME POUR PRÉDIRE LES PERFORMANCES DE DÉMARRAGE DE MOTEUR D'UN SYSTÈME DE STOCKAGE D'ÉNERGIE ÉLECTRIQUE

(30) Priorität: 06.11.2019 DE 102019129902
(43) Veröffentlichungstag der Anmeldung: 14.09.2022
(73) Patentinhaber: Clarios Germany GmbH & Co. KG, 30419 Hannover (DE); Clarios Advanced Solutions GmbH, 30419 Hannover (DE)
(72) Erfinder: SHIRAZI, Sepehr, 30629 Hannover (DE); HOH, Markus, 31515 Wunstorf (DE)
(74) Vertreter: Meissner Bolte Partnerschaft mbB
(86) Internationale Anmeldenummer: PCT/EP2020/073692
(87) Internationale Veröffentlichungsnummer: WO 2021/089214

(56) Entgegenhaltungen:
- DE-A1-102006 000 397
- JP-A- 2011 069 693
- JP-A- 2014 054 083
- US-A1- 2013 085 696

## Beschreibung

Die vorliegende Erfindung betrifft allgemein Verfahren und Systeme zum Abschätzen eines Zustandes eines elektrischen Energiespeichersystems, wie beispielsweise zum Abschätzen einer verbleibenden Kapazität eines elektrischen Energiespeichersystems. Im Einzelnen betrifft die Erfindung Verfahren und Systeme zum Vorhersagen einer Motorstart-Performance eines elektrischen Energiespeichersystems, insbesondere einer Kraftfahrzeug-Starterbatterie.

Unter dem hierin verwendeten Begriff "Motorstart-Performance" ist die Leistungsfähigkeit des elektrischen Energiespeichersystems zu verstehen, einen Fahrzeugmotor eines Kraftfahrzeugs starten zu können, insbesondere kalt- oder warmstarten zu können. Insbesondere umfasst der Begriff "Motorstart-Performance" auch die Leistungsfähigkeit des elektrischen Energiespeichersystems noch eine bestimmte Anzahl von Startvorgängen des Fahrzeugmotors erfolgreich durchführen zu können.

Die Zustandsbestimmung eines elektrischen Energiespeichersystems, insbesondere eines Fahrzeugs, gewinnt mit zunehmenden Fahrzeugfunktionen, welche elektrische Energie zumindest zur Unterstützung benötigen, stark an Bedeutung.

Da vermehrt sicherheitsrelevante Funktionen des Fahrzeugs elektrische Unterstützung erfahren, wird die Zuverlässigkeit der Zustandsbestimmung und Zustandsabschätzung des Energiespeichersystems immer wichtiger.

In elektrischen Energiespeichersystemen mit mehreren wiederaufladbaren Batteriezellen altern die einzelnen Batteriezellen im Laufe der Zeit, wodurch sich die Eigenschaften der Batteriezellen bzw. des gesamten elektrischen Energiespeichersystems verändern. Um im Betrieb die verbleibende Laufzeit des Energiespeichersystems (Akkulaufzeit) zuverlässig vorhersagen zu können, und um Alterungsvorgänge rechtzeitig zu erkennen und entsprechende Maßnahmen ergreifen zu können, ist es wünschenswert, den Alterungszustand des elektrischen Energiespeichersystems möglichst genau bestimmen zu können. Entsprechende Maßnahmen sind beispielsweise gealterte Batteriezellen oder das gesamte elektrische Energiespeichersystem auszutauschen, bevor deren Zustand kritisch wird.

Bekannte Systeme und Verfahren zur Batteriezustandsermittlung greifen in der Regel auf direkte Messwerte des Batteriezustandes und/oder der Batterieeigenschaften zurück, mittels der der Batteriezustand bestimmt wird.

So wird beispielsweise in der Druckschrift DE 19 540 827 C2 ein Verfahren zur Batteriezustandsermittlung angegeben, bei welchem Batterie spezifische Kennfelder der Batteriealterung genutzt werden, um aus erfassten Momentanwerten der Batteriealterungseinflussgrößen mit Hilfe des Kennfeldes einen Batteriealterungswert zu ermitteln.

Auch ist aus der Druckschrift DE 10 335 928 A1 beispielsweise ein Verfahren zum Ermitteln einer auf dem Ladezustand einer Speicherbatterie bezogenen Kenngröße bekannt, bei welchem ein erster auf die hohe Spannung der Batterie bezogener Ladezustandswert und ein zweiter auf die umgesetzte Ladungsmenge bezogener Ladungszustandswert bestimmt werden. Die beiden Ladezustandswerte werden hinsichtlich ihrer Ladezustandsänderungen ausgewertet, um aus den Ladezustandsänderungen eine Kenngröße für den Batteriezustand abzuleiten.

DE 10 2018 131626 A1 betrifft ein Verfahren zum Prognistizieren der Batterielebensdauer.

Diese bekannten Systeme weisen den Nachteil auf, dass größere Fehler in den Messgrößen die Ausgangsgröße unmittelbar beeinflussen, und daher die Zustandsermittlung des Energiespeichersystems nicht eindeutig ist bzw. verfälscht werden kann.

Darüber hinaus existieren Batterietestvorrichtungen, mit denen die Ladungsmenge, die ein Akkumulator speichern kann, vorhergesagt werden kann. Die entnehmbare Kapazität einer Batterie hängt von dem Entladeverlauf ab, also von dem Entladestrom, von der Entladeschlussspannung (= die Spannung, bei welcher die Entladung beendet wird), und von dem Entladungsgrad. Je nach Entladeverlauf besitzt der Akkumulator eine andere Kapazität. In einer aussagekräftigen Angabe der Nennkapazität müssen daher sowohl der Entladestrom als auch die Entladeschlussspannung angegeben werden.

Generell nimmt die entnehmbare Kapazität einer Batterie mit zunehmendem Entladestrom ab. Dieser Effekt wird durch die Peukert-Gleichung beschrieben. Verantwortlich hierfür ist unter anderem der mit steigendem Strom zunehmende Spannungsabfall am Innenwiderstand der Batterie, der die Ausgangsspannung entsprechend absinken lässt, sodass die Entladeschlussspannung früher erreicht wird. Neben dem Innenwiderstand ist auch die begrenzte Geschwindigkeit der elektrochemischen Prozesse und Ladungstransportvorgänge in der Batterie für ihre sinkende Kapazität bei erhöhtem Ladestrom verantwortlich.

Herkömmliche Batterieprüfvorrichtungen basieren darauf, dass der Innenwiderstand der Batterie gemessen wird. Basierend auf dieser Messung kann ein Spannungswert berechnet werden, den die Batterie annehmen wird, wenn ein definiertes Entladeprofil bzw. eine definierte Entladungsart angewandt wird. Als Entladungsarten kommen beispielsweise eine Entladung mit konstantem Strom, eine Entladung über einen konstanten Widerstand oder eine Entladung mit konstanter Leistung in Frage.

Alternativ hierzu ist es möglich, mit dem gemessenen Innenwiderstand der Batterie einen Kaltstartstrom zu berechnen und einen Schwellwert festzulegen, bei welchem die Batterie ausgetauscht werden sollte. Als Beispiel hierzu könnte der Schwellwert bei 50 % des nominellen Kaltstartstroms liegen.

Unter Kaltstartstrom, häufig auch Kälteprüfstrom genannt, wird der maximale Strom verstanden, den eine Batterie bei einer Temperatur von -18° C für 30 Sekunden liefern kann, ehe die Batteriespannung zu niedrig ist. Nach der deutschen Industrienorm (DIN) wird eine vollgeladene 12 V Batterie bei -18° C auf bis zu 6 V entladen, sollte nach 30 Sekunden jedoch noch mindestens 9 V haben und die Grenze von 6 V erst nach 150 Sekunden erreichen. Nach der amerikanischen Norm (SAE) soll eine vollgeladene Batterie bei -18° C nach 30 Sekunden des Entladens noch mindestens 7,2 V haben. Bei der IEC (International Electrotechnical Commission) soll die Batterie bei -18° C nach 60 Sekunden noch 8,4 V haben. Zu guter Letzt soll bei der europäischen Norm (EN) die Entladezeit nach einer Entladung bei einer Schlussspannung von 7,5 V minimal noch 10 Sekunden sein.

Die herkömmlichen Ansätze zum Abschätzen bzw. Vorhersagen einer entnehmbaren Kapazität einer Batterie basieren jedoch auf der Annahme, dass die Batterien in einem vollständig geladenen Zustand (vollgeladen) betrieben werden. Die Randbedingung ist insbesondere bei Start-Stopp-Batterien in der Regel nicht mehr erreichbar, da diese Batterien in der Regel in einem teilgeladenen Zustand betrieben werden (typischerweise bei 70 % bis 80 %).

Darüber hinaus werden bei herkömmlichen Batterieprüfvorrichtungen nicht die Degradation der Batterie berücksichtigt. Unter dem Begriff "Degradation" ist die Abnahme der Kapazität einer Batterie mit der Zeit auch bei sachgemäßer Nutzung zu verstehen, wobei diese Kapazitätsabnahme aufgrund von chemischen Reaktionen (Alterung) stattfindet. Zum einen kommt es durch die Lade- und Entladevorgänge an den Elektroden einer Batterie zu (nur teilweise reversiblen) elektrochemischen Vorgängen, die eine vollständige Aufladung oder Entladung behindern. Hierzu gehören bei Blei-Akkumulatoren die Sulfatierung, bei Batterien auf Nickeltechnologie beispielsweise Batterieträgheitseffekte und bei Batterien auf Lithiumchemie Elektrodenalterung durch unumkehrbare Parasitäre chemische Reaktionen (kalendarische Lebensdauer).

Entsprechende Abnutzung des Akkumulators sind im Verlauf der Nutzung die Ladekapazität und damit auch die Energiedichte.

Durch den zunehmenden Trend der Verwendung von sogenannten Start-Stopp-Systemen bzw. Start-Stopp-Automatik, sind die oben diskutierten Nachteile bei bekannten Systemen zum Abschätzen der Batteriekapazität nicht mehr hinnehmbar. Dies liegt insbesondere daran, dass bei Start-Stopp-Systemen zur Reduzierung des Kraftstoffverbrauches in Standphasen (z. B. bei einem Ampelstopp) der Motor im Stand unter bestimmten Bedingungen abschaltet und ihn wieder automatisch startet. Diese Start-Stopp-Systeme erfordern somit besondere Bedingungen an die Start-Stopp-Batterien.

Eine Start-Stopp-Batterie übernimmt fast die gleichen Aufgaben und Funktionen wie eine reguläre Autobatterie, muss aber noch deutlich mehr leisten, da die Start-Stopp-Automatik ein permanentes An- und Abschalten des Verbrennungsmotors verursacht, was der Batterie ein Höchstmaß an Leistung abverlangt. Von daher ist ersichtlich, dass für ein einwandfreies Funktionieren der Start-Stopp-Automatik eine hinreichend funktionsfähige Batterie verlangt.

Der vorliegenden Erfindung liegt die Aufgabe zu Grunde, ein optimiertes Diagnose- und Analysepool anzugeben, um einen möglichen Batteriedefekt schnell und zuverlässig insbesondere auch für Start-Stopp-Batterien vorhersagen zu können.

Insbesondere soll ein Verfahren zum Abschätzen des Alterungszustandes eines Batteriesystems und insbesondere zum Vorhersagen einer Motorstart-Performance eines Batteriesystems, insbesondere einer Kraftfahrzeug-Starterbatterie, bereitgestellt werden, mit welchem eine möglichst genaue Schätzung des Alterungszustandes des Batteriesystems und insbesondere eine möglichst genaue Vorhersage einer Motorstart-Performance eines Batteriesystems ermöglicht wird.

Eine weitere Aufgabe der Erfindung ist es, ein Verfahren bereitzustellen, welches auf einer Vielzahl verschiedener Energiespeichersysteme und insbesondere Batteriesysteme anwendbar ist, und welches auch bei variierenden Betriebsbedingungen des Energiespeichersystems bzw. Batteriesystems zuverlässige Ergebnisse liefert.

Zur Lösung dieser Aufgabe wird erfindungsgemäß ein Verfahren gemäß dem unabhängigen Patentanspruch 1 sowie ein System gemäß dem nebengeordneten Patentanspruch 13 angegeben.

Die Grundlage des erfindungsgemäßen Verfahrens bildet somit das tatsächliche Anwendungsgebiet des im Hinblick auf die Motorstart-Performance untersuchten elektrischen Energiespeichersystems. Hierbei wird die Erkenntnis ausgenutzt, dass abhängig von dem jeweiligen Einsatz- oder Anwendungsbereich ein Energiespeichersystem trotz fortgeschrittenem Alterungszustand durchaus noch eine hinreichende Motorstart-Performance liefert, um ein bestimmtes Fahrzeug erfolgreich starten zu können. Unter dem hierin verwendeten Begriff "bestimmtes Fahrzeug" ist insbesondere eine bestimmte Fahrzeugmarke, ein bestimmtes Fahrzeugmodel und/oder eine bestimmte Fahrzeugvariante zu verstehen.

Mit anderen Worten, erfindungsgemäß werden für das im Hinblick auf die Motorstart-Performance untersuchte elektrische Energiespeichersystem charakteristische Motorstart-Daten bei einer Vielzahl von unterschiedlichen Anwendungssituationen generiert. Bei den charakteristischen Motorstart-Daten handelt es sich beispielsweise um das Spannungsverhalten im Energiespeichersystem während einer Motorstartphase, die bei einem bestimmten Fahrzeug (d.h., bei einer bestimmten Fahrzeugmarke, bei einem bestimmten Fahrzeugmodel und/oder bei einer bestimmten Fahrzeugvariante) auftreten.

Insbesondere weisen die für das elektrische Energiespeichersystem charakteristischen Motorstart-Daten mindestens eine Motorstart-Spannung und/oder mindestens ein Motorstart-Spannungsprofil des elektrischen Energiespeichersystems bei einer Startphase eines bestimmten Fahrzeuges auf.

In einer Variante hiervon weisen die für das elektrische Energiespeichersystem charakteristischen Motorstart-Daten eine Temperatur des elektrischen Energiespeichersystems beim Generieren der mindestens einen Motorstart-Spannung und/oder beim Generieren des mindestens einen Motorstart-Spannungsprofils auf.

Alternativ oder zusätzlich hierzu weisen die für das elektrische Energiespeichersystem charakteristischen Motorstart-Daten Ladezustandsdaten des elektrischen Energiespeichersystems beim Generieren der mindestens einen Motorstart-Spannung und/oder beim Generieren des mindestens einen Motorstart-Spannungsprofils auf.

Denkbar ist es grundsätzlich, dass die für das elektrische Energiespeichersystem charakteristischen Motorstart-Daten beispielsweise mindestens einen Minimalwert einer Spannung des elektrischen Energiespeichersystems während eines Motorstarts, eine insbesondere von dem Ladezustand des elektrischen Energiespeichersystems abhängige Motorstartzeit, und/oder eine Anzahl der von dem elektrischen Energiespeichersystem bereits durchgeführten Motorstarts auf.

In diesem Zusammenhang bietet es sich grundsätzlich an, dass die für das elektrische Energiespeichersystem charakteristischen Motorstart-Daten von mindestens einem insbesondere in dem von dem elektrischen Energiespeichersystem zu startenden Fahrzeug angeordneten Sensor generiert werden. So ist es beispielsweise denkbar, dass die für das elektrische Energiespeichersystem charakteristischen Motorstart-Daten von einem (fahrzeuginternen) Fahrzeugdiagnosesystem des von dem elektrischen Energiespeichersystem zu startenden Fahrzeuges zur Auswertung generiert und/oder bereitgestellt werden.

Alternativ oder zusätzlich hierzu können die für das elektrische Energiespeichersystem charakteristischen Motorstart-Daten von mindestens einem vorzugsweise direkt an einem elektrischen Anschluss des elektrischen Energiespeichersystems galvanisch angeschlossenen Sensor generiert und/oder bereitgestellt werden.

Erfindungsgemäß ist vorgesehen, dass nicht nur das von dem untersuchten Energiespeichersystem zu startende Fahrzeug (Fahrzeugmodel, Fahrzeugmarke und/oder Fahrzeugvariante), sondern auch die Temperatur oder ein Temperaturbereich eines von dem elektrischen Energiespeichersystem zu startenden Fahrzeugmotors berücksichtigt wird, wobei das ausgegebene Ergebnis der Auswertung eine Vorhersage mit Bezug auf die Motorstart-Performance des elektrischen Energiespeichersystems bei unterschiedlichen Temperaturen des Fahrzeugmotors betrifft.

So ist es beispielsweise denkbar, dass mit Hilfe des erfindungsgemäßen Verfahrens vorhersagbar ist, wie die Motorstart-Performance des elektrischen Energiespeichersystems in Sommermonaten oder Wintermonaten aussieht.

Unter dem hierin verwendeten Begriff "Motorstart-Performance" des elektrischen Energiespeichersystems ist allgemein ein Indikator für eine Leistungsfähigkeit des elektrischen Energiespeichersystems, einen Fahrzeugmotor der bei der Auswertung berücksichtigten Fahrzeugmarke, des bei der Auswertung berücksichtigten Fahrzeugmodels und/oder der bei der Auswertung berücksichtigten Fahrzeugvariante starten, insbesondere Kalt- oder Warmstarten zu können, zu verstehen. Beispielsweise ist die Motorstart-Performance des elektrischen Energiespeichersystems indikativ für eine Anzahl von mit dem elektrischen Energiespeichersystem noch erfolgreich durchführbare Startvorgänge des Fahrzeugmotors. Erfindungsgemäß wird anhand von Trainingsdaten ein Vorhersagemodel bzw. Alterungsmodel des elektrischen Energiespeichersystems erstellt und/oder kontinuierlich optimiert. Zu diesem Zweck werden zum Auswerten der generierten Motorstart-Daten die Motorstart-Daten in einen auf dem Prinzip des maschinellen Lernens basierenden Motorstart-Vorhersage-Algorithmus eingegeben. In dem Motorstart-Vorhersage-Algorithmus können die Motorstart-Daten gemäß Klassifikationen in unterschiedliche Kategorien eingeteilt werden, wobei sich die unterschiedlichen Muster unterscheiden. Insbesondere werden dabei die Motorstart-Daten abhängig von einer Fahrzeugmarke, einem Fahrzeugmodel und/oder einer Fahrzeugvariante des von dem elektrischen Energiespeichersystem zu startenden Fahrzeuges in unterschiedliche Kategorien eingeteilt.

Bei dem erfindungsgemäßen Verfahren ist insbesondere vorgesehen, dass eine Lernphase des Motorstart-Vorhersage-Algorithmus durchgeführt wird. In der Lernphase werden Lerndaten in den Motorstart-Vorhersage-Algorithmus eingegeben, wobei der Motorstart-Vorhersage-Algorithmus nach dem Prinzip des maschinellen Lernens in den eingegebenen Lerndaten Muster und/oder Gesetzmäßigkeiten erkennt, welche beim Auswerten der generierten Motorstart-Daten entsprechend angewandt werden. Die Lerndaten weisen insbesondere charakteristische Motorstart-Daten einer Vielzahl von insbesondere unterschiedlich gealterter elektrischen Energiespeichersysteme von einer Vielzahl unterschiedlicher Fahrzeugmarken, Fahrzeugmodelle und/oder Fahrzeugvarianten auf.

Gemäß einer bevorzugten Weiterbildung ist vorgesehen, dass die generierten Motorstart-Daten des elektrischen Energiespeichersystems, dessen Motorstart-Performance vorherzusagen ist, während einer Lernphase des Motorstart-Vorhersage-Algorithmus als Lerndaten verwendet werden.

Die Erfindung betrifft ferner ein System zum Vorhersagen einer Motorstart-Performance eines elektrischen Energiespeichersystems, wobei das System eine Eingabeschnittstelle zum Eingeben von für das elektrische Energiespeichersystem charakteristischen Motorstart-Daten und eine Auswertung zum Auswerten der eingegebenen Motorstart-Daten aufweist. Dabei ist die Auswerteeinrichtung ausgebildet, bei der Auswertung der Motorstart-Daten eine Fahrzeugmarke, ein Fahrzeugmodel und/oder eine Fahrzeugvariante eines von dem elektrischen Energiespeichersystem zu startenden Fahrzeuges zu berücksichtigen. Die Auswerteeinrichtung weist insbesondere einen auf dem Prinzip des maschinellen Lernens basierenden Motorstart-Vorhersage-Algorithmus auf.

Nachfolgend wird unter Bezugnahme auf die beiliegende Zeichnung eine exemplarische Ausführungsform des erfindungsgemäßen Verfahrens bzw. des erfindungsgemäßen Systems näher beschrieben.

Es zeigt:

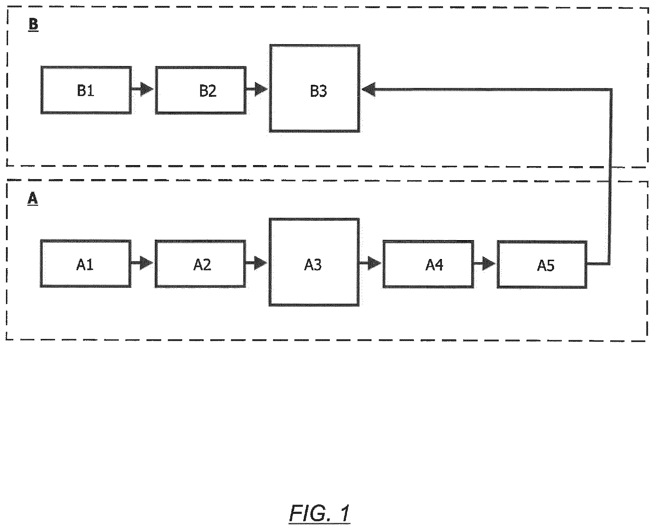

- FIG. 1: schematisch ein Ablaufdiagramm einer exemplarischen Ausführungsform des erfindungsgemäßen Verfahrens.

Herkömmliche Batterietestsysteme versuchen, die Fähigkeit eines Energiespeichersystems bzw. einer Batterie, einen Verbrennungsmotor zu starten, vorherzusagen. Dies basiert in der Regel auf einer Messung des Innenwiderstands (IR) des Energiespeichersystems oder der Leitfähigkeit. Basierend auf dieser Messung kann ein Spannungswert berechnet werden, den das Energiespeichersystem haben wird, wenn ein definiertes Stromprofil angelegt wird.

Ein zweiter Ansatz besteht darin, mit dem Innenwiderstand des Energiespeichersystems einen so genannten Kaltstartstrom (cold crank current - CCA) zu berechnen und einen Schwellenwert festzulegen, bei dem das Energiespeichersystem ausgetauscht werden soll (beispielsweise bei 50 % des nominalen CCA-Wertes). Der Nachteil der herkömmlichen Batterietestgeräte ist insbesondere darin zu sehen, dass die Art der Vorhersage die Leistung bzw. Performance des Energiespeichersystems nur bei einem vordefinierten Stromwert unter Laborbedingungen und einem festen (geschätzten) Schwellenwert, wie beispielsweise 50 % des nominalen CCA-Wertes, berücksichtigt. Von daher sind herkömmliche Batterietestgeräte nicht in der Lage, eine "echte" Motorstartkondition widerzuspiegeln.

Unter Berücksichtigung aller Variationen von Fahrzeugmarken und Fahrzeugmodellen, Variationen von Batterie- und Umgebungstemperaturen, unter Berücksichtigung des Einflusses von SOC-Variationen usw., können herkömmliche Batterietestverfahren bzw. Batterietestgeräte in der Praxis nur eine unzureichende Vorhersage der Batterieleistung für einen echten Motorstartvorgang in einem Fahrzeug liefern.

Insbesondere wird bei aus dem Stand der Technik bekannten Verfahren zur Vorhersage der Batterieleistung nicht der Hauptgrund für einen Batterieausfall, der eine alterungsbedingte Abnahme der Leistung der Batterie zum Starten des Verbrennungsmotors ist, berücksichtigt.

Hingegen wird nach der Erfindung eine fahrzeugbasierte elektrische Leistungsaufnahme beim Motorstart verwendet, um die Vorhersage der Motorstart-Performance des Energiespeichersystems anzupassen.

Bei der vorliegenden Erfindung wird insbesondere eine Diskrepanz zwischen den derzeitigen Batterietestern, die zur Abschätzung der Batterieleistung unter Laborbedingungen entwickelt sind, und der tatsächlichen Batterieleistung, die zum Starten des Verbrennungsmotors des Fahrzeuges benötigt wird (für verschiedene Fahrzeugmarken, Fahrzeugmodelle, Motortechnologien wie Diesel, Benziner, Start/Stopp, usw.) berücksichtigt.

Das erfindungsgemäße Verfahren, wie es schematisch in FIG. 1 gezeigt ist, basiert im Prinzip auf zwei kombinierten Verfahren.

Der erste Schritt A des Verfahrens bildet die Grundlage für den Fahrzeugstart-Vorhersage-Algorithmus. Für die Implementation des Verfahrensschrittes A werden eine Vielzahl von verschiedenen Fahrzeugmarken und Fahrzeugmodellen verwendet (beispielsweise 100 Fahrzeuge).

Wie als Block A1 "Fahrzeugdaten-Aufnahme" angedeutet, dienen als Eingangsdaten dienen unterschiedliche, bei einem Motorstart aufgenommene Spannungsprofile, und zwar bei einer Vielzahl von unterschiedlich gealterten Batterien, bei unterschiedlichen Temperaturen und unterschiedlichen SOC-Bedingungen.

In einem zweiten Schritt (Block A2 - "Datenauswertung") kategorisiert ein intelligenter maschineller Lernalgorithmus die verschiedenen Spannungsprofile (beispielsweise Minimalspannung, Startzeit, Anzahl der erfolgreichen Motorstarts, etc.) für verschiedene Fahrzeugmarken und Fahrzeugmodelle und definiert Leistungsgrenzen für erfolgreiche und erfolglose Motorstartvorgänge.

Der große Vorteil dieses Verfahrens besteht darin, dass die Motorstartreaktion des Fahrzeuges für verschiedene Variationen (Fahrzeugmarken und Modelle, Temperaturen, SOC, etc.) später in einem Batterietester für eine Batteriewechselempfehlung und nicht unbekannte batterieinterne (chemische) Reaktionen verwendet werden kann.

Das Batterietestgerät kann die Motorstartdaten des Verbrennungsmotors direkt an den Anschlusspolen des Energiespeichersystems erfassen oder diese Werte an anderen Stellen, beispielsweise am OBD-Port des Fahrzeuges über den Analog-Ausgangspin erfassen.

Zum Auswerten der generierten Motorstart-Daten werden dann die Motorstart-Daten in einen auf dem Prinzip des maschinellen Lernens basierenden Motorstart-Vorhersage-Algorithmus eingegeben (Block A3 - "Motorstart-Vorhersage-Algorithmus").

In dem Motorstart-Vorhersage-Algorithmus werden die Motorstart-Daten gemäß Klassifikationen in unterschiedliche Kategorien eingeteilt, die sich durch charakteristische Muster unterscheiden (Block A4 - "Klassifikation"), wobei dann die Motorstart-Daten abhängig von einer Fahrzeugmarke, einem Fahrzeugmodell und/oder einer Fahrzeugvariante des von dem elektrischen Energiespeichersystem zu startenden Fahrzeugs in unterschiedliche Kategorien eingeteilt werden (Block A5 - "Auswertung").

Da für eine möglichst zuverlässige Vorhersage ein Basisalgorithmus benötigt wird, der auf dem Grundprinzip des maschinellen Lernens beruht, ist es von Vorteil, wenn dem Algorithmus möglichst viele Lerndaten zur Verfügung gestellt werden.

Zu diesem Zweck kommt ein weiterer Verfahrensschritt (Schritt B) zum Einsatz, welches eine Cloud-basierte Datenstruktur benötigt, welche alle durch den ersten Verfahrensschritt A definierten Werte beinhaltet. Die Idee ist es, dass ein Batterietester in einem ersten Schritt den Basisalgorithmus beinhaltet und in einer Pilot- oder Lernphase mit einer Beta-Version arbeitet und in mehreren Durchgängen weitere Motorstartdaten sammelt, welche automatisch an die Cloud-Datenbank gesendet werden.

Im Einzelnen ist in FIG. 1 die Cloud-basierte Datenstruktur mit dem Bezugszeichen B1 bezeichnet. Der Verfahrensschritt B zeichnet sich dadurch aus, dass eine Lernphase eines Motorstart-Vorhersage-Algorithmus durchgeführt wird, wobei in der Lernphase Lerndaten B2 in den Motorstart-Vorhersage-Algorithmus eingegeben werden, und wobei der Motorstart-Vorhersage-Algorithmus in den eingegebenen Lerndaten Muster und/oder Gesetzmäßigkeiten erkennt, welche beim Auswerten der generierten Motorstart-Daten entsprechend angewandt werden (Block B3 - "Training").

Die Lerndaten weisen insbesondere charakteristische Motorstart-Daten einer Vielzahl von insbesondere unterschiedlich gealterten elektrischen Energiespeichersystemen von einer Vielzahl unterschiedlicher Fahrzeugmarken, Fahrzeugmodelle und/oder Fahrzeugvarianten auf.

Die generierten Motorstart-Daten des elektrischen Energiespeichersystems, dessen Motorstart-Performance vorherzusagen ist, können dann während einer Lernphase des Motorstart-Vorhersage-Algorithmus als Lerndaten verwendet werden.

Ein maschineller Lernalgorithmus wertet diese neuen Motorstartdaten aus und passt die Anzeige an, um den Motorstart-Vorhersage-Algorithmus und seine Schwellenwerte zu optimieren. Von Zeit zu Zeit (d.h. nach einer ausreichenden Anzahl neuer Motorstartdaten verschiedener Fahrzeugmodelle) wird die "alte" Algorithmenversion durch eine optimierte Version aktualisiert. Der Algorithmus selbst kann in einer Batterietestereinheit verwendet/implementiert sein und/oder er könnte als Cloud-basierter Algorithmus verwendet werden.

Zusammenfassend bleibt somit Folgendes festzuhalten:
Erfindungsgemäß werden zunächst charakteristische Motorstart-Daten für das untersuchte elektrische Energiespeichersystem generiert.

Diese Motorstart-Daten werden vorzugsweise direkt im Fahrzeug mit Hilfe entsprechender Sensoren generiert, wie beispielsweise Sensoren, die zu dem Fahrzeugdiagnosesystem gehören. Die charakteristischen Motorstart-Daten sind die "echten" Daten, die ein Energiespeichersystem beim Startvorgang eines echten Verbrennungsmotors für unterschiedliche Fahrzeugmarken, Fahrzeugmodelle und Fahrzeugvarianten erzeugt. Hierbei handelt es sich insbesondere um eine Motorstart-Spannung und/oder ein Motorstart-Spannungsprofil, aber auch die Temperatur des elektrischen Energiespeichersystems beim Generieren der Motorstart-Spannung bzw. des Motorstart-Spannungsprofils kann berücksichtigt werden, wie ebenso ein Ladezustand des Energiespeichersystems während der MotorstartPhase.

Mit anderen Worten, die Eingangsdaten für einen auf dem maschinellen Lernen basierenden Auswerte-Algorithmus sind keinesfalls Labordaten des Energiespeichersystems, sondern Daten, die unter reellen Bedingungen aufgenommen werden, wobei hier insbesondere berücksichtigt wird, bei welcher Fahrzeugmarke, bei welchem Fahrzeugmodell und/oder bei welcher Fahrzeugvariante die echten Motorstart-Daten generiert werden.

Der auf dem maschinellen Lernen basierende Auswerte-Algorithmus teilt anschließend die Motorstart-Daten, die als Lerndaten dienen, in unterschiedliche Kategorien ein.

Dadurch wird ein Motorstart-Vorhersage-Algorithmus bereitgestellt, der aufgrund einer vorzugsweise kontinuierlich oder periodisch durchgeführten Lernphase regelmäßig mit neuen Lerndaten gespeist wird, um so seine Genauigkeit zu optimieren.

Mit dem derart gebildeten Auswerte-Algorithmus können dann Energiespeichersysteme im Hinblick auf ein bestimmtes Fahrzeugmodell bzw. eine bestimmte Fahrzeugmarke und/oder eine bestimmte Fahrzeugvariante besonders genau bewertet werden, und zwar im Hinblick auf die Frage, wie die Motorstart-Performance des elektrischen Energiespeichersystems bei der bestimmten Fahrzeugmarke, dem bestimmten Fahrzeugmodell und/oder der bestimmten Fahrzeugvariante ausschaut.

Die Erfindung ist nicht auf das in der Zeichnung schematisch gezeigte Verfahren beschränkt, sondern ergibt sich aus einer Zusammenschau sämtlicher hierin offenbarter Merkmale.

## Patentansprüche

1. Verfahren zum Vorhersagen einer Leistungsfähigkeit eines elektrischen Energiespeichersystems, einen Fahrzeugmotor einer bestimmten Fahrzeugmarke, eines bestimmten Fahrzeugmodels und/oder einer bestimmten Fahrzeugvariante starten zu können, wobei das elektrische Energiespeichersystem eine Kraftfahrzeug-Starterbatterie ist, und wobei das Verfahren die folgenden Verfahrensschritte aufweist:
- Generieren von für das elektrische Energiespeichersystem charakteristischen Motorstart-Daten;
- Auswerten der generierten Motorstart-Daten; und
- Ausgeben eines Ergebnisses der Auswertung, welches eine Vorhersage mit Bezug auf die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, betrifft,
wobei zum Auswerten der generierten Motorstart-Daten die Fahrzeugmarke, das Fahrzeugmodell und/oder die Fahrzeugvariante des von dem elektrischen Energiespeichersystem zu startenden Fahrzeugs berücksichtigt wird,
wobei zum Auswerten der generierten Motorstart-Daten eine Temperatur oder ein Temperaturbereich eines von dem elektrischen Energiespeichersystem zu startenden Fahrzeugmotors berücksichtigt wird, und wobei das ausgegebene Ergebnis der Auswertung eine Vorhersage mit Bezug auf die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, bei unterschiedlichen Temperaturen des Fahrzeugmotors betrifft; und/oder wobei die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, eine Leistungsfähigkeit des elektrischen Energiespeichersystems ist, einen Fahrzeugmotor der bei der Auswertung berücksichtigten Fahrzeugmarke, des bei der Auswertung berücksichtigten Fahrzeugmodells und/oder der bei der Auswertung berücksichtigten Fahrzeugvariante kalt- oder warmstarten zu können.

2. Verfahren nach Anspruch 1,
wobei die für das elektrische Energiespeichersystem charakteristischen Motorstart-Daten mindestens eine Motorstart-Spannung und/oder mindestens ein Motorstart-Spannungsprofil des elektrischen Energiespeichersystems aufweisen.

3. Verfahren nach Anspruch 2,
wobei die für das elektrische Energiespeichersystem charakteristischen Motorstart-Daten eine Temperatur des elektrischen Energiespeichersystems beim Generieren der mindestens einen Motorstart-Spannung und/oder beim Generieren des mindestens einen Motorstart-Spannungsprofils aufweisen; und/oder
wobei die für das elektrische Energiespeichersystem charakteristischen Motorstart-Daten Ladezustandsdaten des elektrischen Energiespeichersystems beim Generieren der mindestens einen Motorstart-Spannung und/oder beim Generieren des mindestens einen Motorstart-Spannungsprofils aufweisen.

4. Verfahren nach einem der Ansprüche 1 bis 3,
wobei die für das elektrische Energiespeichersystem charakteristischen Motorstart-Daten mindestens einen Minimalwert einer Spannung des elektrischen Energiespeichersystems während eines Motorstarts, eine insbesondere von dem Ladezustand des elektrischen Energiespeichersystems abhängige Motorstartzeit, und/oder eine Anzahl der von dem elektrischen Energiespeichersystem bereits durchgeführten Motorstarts aufweisen.

5. Verfahren nach einem der Ansprüche 1 bis 4,
wobei die für das elektrische Energiespeichersystem charakteristischen Motorstart-Daten von mindestens einem insbesondere in dem von dem elektrischen Energiespeichersystem zu startenden Fahrzeug angeordneten Sensor generiert werden.

6. Verfahren nach einem der Ansprüche 1 bis 5,
wobei die für das elektrische Energiespeichersystem charakteristischen Motorstart-Daten von einem Fahrzeugdiagnosesystem des von dem elektrischen Energiespeichersystem zu startenden Fahrzeugs zur Auswertung generiert und/oder bereitgestellt werden, und/oder
wobei die für das elektrische Energiespeichersystem charakteristischen Motorstart-Daten von mindestens einem vorzugsweise direkt an einem elektrischen Anschluss des elektrischen Energiespeichersystems galvanisch angeschlossenen Sensor generiert und/oder bereitgestellt werden.

7. Verfahren nach einem der Ansprüche 1 bis 6,
wobei die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, indikativ für eine Anzahl von mit dem elektrischen Energiespeichersystem noch erfolgreich durchführbare Startvorgänge des Fahrzeugmotors ist.

8. Verfahren nach einem der Ansprüche 1 bis 7,
wobei zum Auswerten der generierten Motorstart-Daten die Motorstart-Daten in einen auf dem Prinzip des maschinellen Lernens basierenden Motorstart-Vorhersage-Algorithmus eingegeben werden.

9. Verfahren nach einem der Ansprüche 1 bis 8,
wobei zum Auswerten der generierten Motorstart-Daten die Motorstart-Daten in einen Motorstart-Vorhersage-Algorithmus eingegeben werden, in welchem die Motorstart-Daten gemäß Klassifikationen in unterschiedliche Kategorien eingeteilt werden, die sich durch charakteristische Muster unterscheiden.

10. Verfahren nach Anspruch 9,
wobei die Motorstart-Daten abhängig von einer Fahrzeugmarke, einem Fahrzeugmodell und/oder einer Fahrzeugvariante des von dem elektrischen Energiespeichersystem zu startenden Fahrzeugs in unterschiedliche Kategorien eingeteilt werden.

11. Verfahren nach einem der Ansprüche 1 bis 10,
wobei das Verfahren ferner den Verfahrensschritt des Durchführens einer Lernphase eines Motorstart-Vorhersage-Algorithmus aufweist, wobei in der Lernphase Lerndaten in den Motorstart-Vorhersage-Algorithmus eingegeben werden, und wobei der Motorstart-Vorhersage-Algorithmus in den eingegebenen Lerndaten Muster und/oder Gesetzmäßigkeiten erkennt, welche beim Auswerten der generierten Motorstart-Daten entsprechend angewandt werden.

12. Verfahren nach Anspruch 11,
wobei die Lerndaten charakteristische Motorstart-Daten eine Vielzahl von insbesondere unterschiedlich gealterten elektrischen Energiespeichersystemen von einer Vielzahl unterschiedlicher Fahrzeugmarken, Fahrzeugmodelle und/oder Fahrzeugvarianten aufweisen; und/oder
wobei die generierten Motorstart-Daten des elektrischen Energiespeichersystems, dessen Motorstart-Performance vorherzusagen ist, während einer Lernphase des Motorstart-Vorhersage-Algorithmus als Lerndaten verwendet werden.

13. System zum Vorhersagen einer Leistungsfähigkeit eines elektrischen Energiespeichersystems, einen Fahrzeugmotor einer bestimmten Fahrzeugmarke, eines bestimmten Fahrzeugmodels und/oder einer bestimmten Fahrzeugvariante starten zu können, wobei das elektrische Energiespeichersystem eine Kraftfahrzeug-Starterbatterie ist, wobei das System eine Eingabeschnittstelle zum Eingeben von für das elektrische Energiespeichersystem charakteristischen Motorstart-Daten und eine Auswerteeinrichtung zum Auswerten der eingegebenen Motorstart-Daten aufweist, wobei die Auswerteeinrichtung ausgebildet ist, bei der Auswertung der Motorstart-Daten eine Fahrzeugmarke, ein Fahrzeugmodell und/oder eine Fahrzeugvariante eines von dem elektrischen Energiespeichersystem zu startenden Fahrzeugs zu berücksichtigen;
wobei zum Auswerten der generierten Motorstart-Daten eine Temperatur oder ein Temperaturbereich eines von dem elektrischen Energiespeichersystem zu startenden Fahrzeugmotors berücksichtigt wird, und wobei das ausgegebene Ergebnis der Auswertung eine Vorhersage mit Bezug auf die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, bei unterschiedlichen Temperaturen des Fahrzeugmotors betrifft; und/oder wobei die Leistungsfähigkeit des elektrischen Energiespeichersystems, einen Fahrzeugmotor einer bestimmten Fahrzeugmarke, eines bestimmten Fahrzeugmodels und/oder einer bestimmten Fahrzeugvariante starten zu können, eine Leistungsfähigkeit des elektrischen Energiespeichersystems ist, einen Fahrzeugmotor der bei der Auswertung berücksichtigten Fahrzeugmarke, des bei der Auswertung berücksichtigten Fahrzeugmodells und/oder der bei der Auswertung berücksichtigten Fahrzeugvariante kalt- oder warmstarten zu können.

14. System nach Anspruch 13,
wobei die Auswerteeinrichtung einen auf dem Prinzip des maschinellen Lernens basierenden Motorstart-Vorhersage-Algorithmus aufweist.

15. System nach Anspruch 13 oder 14,
wobei das System eine Ausgabeschnittstelle aufweist zum Ausgeben eines Ergebnisses der von der Auswerteeinrichtung durchgeführten Auswertung, und wobei das System zur Durchführung des Verfahrens nach einem der Ansprüche 1 bis 13 ausgebildet ist.

## Claims

1. Method for predicting an ability of an electrical energy storage system to be able to start a vehicle engine of a particular vehicle make, a particular vehicle model and/or a particular vehicle variant, wherein the electrical energy storage system is a motor vehicle starter battery, and wherein the method comprises the following method steps:
- generating engine-start data which are characteristic of the electrical energy storage system;
- evaluating the generated engine-start data; and
- outputting a result of the evaluation, which result relates to a prediction with respect to the ability of the electrical energy storage system to be able to start a vehicle engine of a particular vehicle make, a particular vehicle model and/or a particular vehicle variant,
wherein the vehicle make, the vehicle model and/or the vehicle variant of the vehicle to be started by the electrical energy storage system is/are taken into account in order to evaluate the generated engine-start data, wherein a temperature or a temperature range of a vehicle engine to be started by the electrical energy storage system is taken into account in order to evaluate the generated engine-start data, and wherein the output result of the evaluation relates to a prediction with respect to the ability of the electrical energy storage system to be able to start a vehicle engine of a particular vehicle make, a particular vehicle model and/or a particular vehicle variant at different temperatures of the vehicle engine; and/or wherein the ability of the electrical energy storage system to be able to start a vehicle engine of a particular vehicle make, a particular vehicle model and/or a particular vehicle variant is an ability of the electrical energy storage system to be able to cold-start or warm-start a vehicle engine of the vehicle make taken into account in the evaluation, the vehicle model taken into account in the evaluation and/or the vehicle variant taken into account in the evaluation.

2. Method according to Claim 1,
wherein the engine-start data which are characteristic of the electrical energy storage system comprise at least one engine-start voltage and/or at least one engine-start voltage profile of the electrical energy storage system.

3. Method according to Claim 2,
wherein the engine-start data which are characteristic of the electrical energy storage system comprise a temperature of the electrical energy storage system when the at least one engine-start voltage is generated and/or when the at least one engine-start voltage profile is generated; and/or
wherein the engine-start data which are characteristic of the electrical energy storage system comprise state of charge data of the electrical energy storage system when the at least one engine-start voltage is generated and/or when the at least one engine-start voltage profile is generated.

4. Method according to one of Claims 1 to 3,
wherein the engine-start data which are characteristic of the electrical energy storage system comprise at least one minimum value of a voltage of the electrical energy storage system during an engine start, an engine-start time which is dependent in particular on the state of charge of the electrical energy storage system, and/or a number of engine starts already carried out by the electrical energy storage system.

5. Method according to one of Claims 1 to 4,
wherein the engine-start data which are characteristic of the electrical energy storage system are generated by at least one sensor arranged in particular in the vehicle to be started by the electrical energy storage system.

6. Method according to one of Claims 1 to 5,
wherein the engine-start data which are characteristic of the electrical energy storage system are generated and/or provided by a vehicle diagnostic system of the vehicle to be started by the electrical energy storage system for evaluation, and/or
wherein the engine-start data which are characteristic of the electrical energy storage system are generated and/or provided by at least one sensor which is preferably galvanically connected directly to an electrical connection of the electrical energy storage system.

7. Method according to one of Claims 1 to 6,
wherein the ability of the electrical energy storage system to be able to start a vehicle engine of a particular vehicle make, a particular vehicle model and/or a particular vehicle variant is indicative of a number of vehicle engine start processes which can still be carried out successfully by way of the electrical energy storage system.

8. Method according to one of Claims 1 to 7,
wherein the engine-start data are input into an engine-start prediction algorithm based on the principle of machine learning in order to evaluate the generated engine-start data.

9. Method according to one of Claims 1 to 8,
wherein, in order to evaluate the generated engine-start data, the engine-start data are input into an engine-start prediction algorithm, in which the engine-start data are divided according to classifications into different categories, which differ in characteristic patterns.

10. Method according to Claim 9,
wherein the engine-start data are divided into different categories depending on a vehicle make, a vehicle model and/or a vehicle variant of the vehicle to be started by the electrical energy storage system.

11. Method according to one of Claims 1 to 10,
wherein the method further comprises the method step of performing a learning phase of an engine-start prediction algorithm, wherein learning data are input into the engine-start prediction algorithm in the learning phase, and wherein the engine-start prediction algorithm identifies patterns and/or regularities in the input learning data, which patterns and/or regularities are used accordingly when evaluating the generated engine-start data.

12. Method according to Claim 11,
wherein the learning data comprise characteristic engine-start data for a large number of electrical energy storage systems, in particular those that have aged differently, from a large number of different vehicle makes, vehicle models and/or vehicle variants; and/or
wherein the generated engine-start data of the electrical energy storage system whose engine-start performance is to be predicted are used as learning data during a learning phase of the engine-start prediction algorithm.

13. System for predicting an ability of an electrical energy storage system to be able to start a vehicle engine of a particular vehicle make, a particular vehicle model and/or a particular vehicle variant, wherein the electrical energy storage system is a motor vehicle starter battery, wherein the system comprises an input interface for inputting engine-start data which are characteristic of the electrical energy storage system and an evaluation device for evaluating the input engine-start data, wherein the evaluation device is designed to take into account a vehicle make, a vehicle model and/or a vehicle variant of a vehicle to be started by the electrical energy storage system when evaluating the engine-start data;
wherein a temperature or a temperature range of a vehicle engine to be started by the electrical energy storage system is taken into account in order to evaluate the generated engine-start data, and wherein the output result of the evaluation relates to a prediction with respect to the ability of the electrical energy storage system to be able to start a vehicle engine of a particular vehicle make, a particular vehicle model and/or a particular vehicle variant at different temperatures of the vehicle engine; and/or wherein the ability of the electrical energy storage system to be able to start a vehicle engine of a particular vehicle make, a particular vehicle model and/or a particular vehicle variant is an ability of the electrical energy storage system to be able to cold-start or warm-start a vehicle engine of the vehicle make taken into account in the evaluation, the vehicle model taken into account in the evaluation and/or the vehicle variant taken into account in the evaluation.

14. System according to Claim 13,
wherein the evaluation device comprises an engine-start prediction algorithm based on the principle of machine learning.

15. System according to Claim 13 or 14,
wherein the system comprises an output interface for outputting a result of the evaluation carried out by the evaluation device, and wherein the system is designed to carry out the method according to one of Claims 1 to 13.

## Revendications

1. Procédé de prédiction de la capacité d'un système de stockage d'énergie électrique à pouvoir démarrer un moteur de véhicule d'une marque de véhicule déterminée, d'un modèle de véhicule déterminé et/ou d'une variante de véhicule déterminée, le système de stockage d'énergie électrique étant une batterie de démarreur de véhicule automobile, et le procédé comprenant les étapes suivantes :
- génération de données de démarrage de moteur caractéristiques pour le système de stockage d'énergie électrique ;
- interprétation des données de démarrage de moteur ; et
- délivrance en sortie d'un résultat de l'interprétation, lequel concerne une prédiction, en référence à la capacité du système de stockage d'énergie électrique, à pouvoir démarrer un moteur de véhicule d'une marque de véhicule déterminée, d'un modèle de véhicule déterminé et/ou d'une variante de véhicule déterminée,
la marque de véhicule déterminée, le modèle de véhicule et/ou la variante de véhicule du véhicule à démarrer par le système de stockage d'énergie électrique étant pris en compte pour l'interprétation des données de démarrage de moteur générées,
une température ou une plage de températures d'un moteur de véhicule à démarrer par le système de stockage d'énergie électrique étant prise en compte pour l'interprétation des données de démarrage de moteur générées, et le résultat délivré en sortie de l'interprétation concernant une prédiction, en référence à la capacité du système de stockage d'énergie électrique, à pouvoir démarrer un moteur de véhicule d'une marque de véhicule déterminée, d'un modèle de véhicule déterminé et/ou d'une variante de véhicule déterminée en présence de différentes températures du moteur de véhicule ; et/ou
la capacité du système de stockage d'énergie électrique à pouvoir démarrer un moteur de véhicule d'une marque de véhicule déterminée, d'un modèle de véhicule déterminé et/ou d'une variante de véhicule déterminée étant une capacité du système de stockage d'énergie électrique à pouvoir démarrer à froid ou à chaud un moteur de véhicule de la marque de véhicule prise en compte lors de l'interprétation, du modèle de véhicule pris en compte lors de l'interprétation et/ou de la variante de véhicule prise en compte lors de l'interprétation.

2. Procédé selon la revendication 1,
les données de démarrage de moteur caractéristiques pour le système de stockage d'énergie électrique comprenant au moins une tension de démarrage de moteur et/ou au moins un profil de tension de démarrage de moteur du système de stockage d'énergie électrique.

3. Procédé selon la revendication 2,
les données de démarrage de moteur caractéristiques pour le système de stockage d'énergie électrique comprenant une température du système de stockage d'énergie électrique lors de la génération de l'au moins une tension de démarrage de moteur et/ou lors de la génération de l'au moins un profil de tension de démarrage de moteur ; et/ou
les données de démarrage de moteur caractéristiques pour le système de stockage d'énergie électrique comprenant des données d'état de charge du système de stockage d'énergie électrique lors de la génération de l'au moins une tension de démarrage de moteur et/ou lors de la génération de l'au moins un profil de tension de démarrage de moteur.

4. Procédé selon l'une des revendications 1 à 3,
les données de démarrage de moteur caractéristiques pour le système de stockage d'énergie électrique comprenant au moins une valeur minimale d'une tension du système de stockage d'énergie électrique pendant un démarrage de moteur, un temps de démarrage de moteur qui dépend notamment de l'état de charge du système de stockage d'énergie électrique et/ou un nombre de démarrages de moteur déjà effectués par le système de stockage d'énergie électrique.

5. Procédé selon l'une des revendications 1 à 4,
les données de démarrage de moteur caractéristiques pour le système de stockage d'énergie électrique étant générées par au moins un capteur, notamment disposé dans le véhicule à démarrer par le système de stockage d'énergie électrique.

6. Procédé selon l'une des revendications 1 à 5,
les données de démarrage de moteur caractéristiques pour le système de stockage d'énergie électrique étant générées et/ou mises à disposition par un système de diagnostic de véhicule du véhicule à démarrer par le système de stockage d'énergie électrique en vue de l'interprétation, et/ou
les données de démarrage de moteur caractéristiques pour le système de stockage d'énergie électrique étant générées et/ou mises à disposition par au moins un capteur raccordé galvaniquement, de préférence directement, à une borne électrique du système de stockage d'énergie électrique.

7. Procédé selon l'une des revendications 1 à 6,
la capacité du système de stockage d'énergie électrique à pouvoir démarrer un moteur de véhicule d'une marque de véhicule déterminée, d'un modèle de véhicule déterminé et/ou d'une variante de véhicule déterminée étant indicative d'un nombre d'opérations de démarrage du moteur de véhicule qui peuvent encore être menées à bien avec le système de stockage d'énergie électrique.

8. Procédé selon l'une des revendications 1 à 7,
en vue d'interpréter les données de démarrage de moteur, les données de démarrage de moteur étant prises comme entrée d'un algorithme de prédiction de démarrage de moteur basé sur le principe de l'apprentissage automatique.

9. Procédé selon l'une des revendications 1 à 8,
en vue d'interpréter les données de démarrage de moteur, les données de démarrage de moteur étant prises comme entrée d'un algorithme de prédiction de démarrage de moteur dans lequel les données de démarrage de moteur sont, conformément à des classifications, réparties en différentes catégories qui se différentient par des modèles caractéristiques.

10. Procédé selon la revendication 9,
les données de démarrage de moteur étant réparties en différentes catégories en fonction d'une marque de véhicule, d'un modèle de véhicule et/ou d'une variante de véhicule du véhicule à démarrer par le système de stockage d'énergie électrique.

11. Procédé selon l'une des revendications 1 à 10,
le procédé comprenant en outre l'étape d'exécution d'une phase d'apprentissage d'un algorithme de prédiction de démarrage de moteur, des données d'apprentissage étant prises comme entrée de l'algorithme de prédiction de démarrage de moteur dans la phase d'apprentissage et l'algorithme de prédiction de démarrage de moteur reconnaissant, dans les données prises comme entrée, des modèles et/ou des légitimités qui sont employés en conséquence lors de l'interprétation des données de moteur générées.

12. Procédé selon la revendication 11,
les données d'apprentissage des données de démarrage de moteur caractéristiques comprenant une pluralité de systèmes de stockage d'énergie électrique, notamment ayant vieilli différemment, d'une pluralité de marques de véhicule, de modèles de véhicule et/ou de variantes de véhicule différents ; et/ou
les données de démarrage de moteur générées du système de stockage d'énergie électrique, dont les performances de démarrage de moteur doivent être prédites, étant utilisées en tant que données d'apprentissage pendant une phase d'apprentissage de l'algorithme de prédiction de démarrage de moteur.

13. Système de prédiction de la capacité d'un système de stockage d'énergie électrique à pouvoir démarrer un moteur de véhicule d'une marque de véhicule déterminée, d'un modèle de véhicule déterminé et/ou d'une variante de véhicule déterminée, le système de stockage d'énergie électrique étant une batterie de démarreur de véhicule automobile, le système possédant une interface d'entrée destinée à l'entrée de données de démarrage de moteur caractéristiques pour le système de stockage d'énergie électrique et un dispositif d'interprétation destiné à interpréter les données de démarrage de moteur prises comme entrée, le dispositif d'interprétation étant configuré pour, lors de l'interprétation des données de démarrage de moteur, tenir compte d'une marque de véhicule, d'un modèle de véhicule et/ou d'une variante de véhicule d'un véhicule à démarrer par le système de stockage d'énergie électrique ;
une température ou une plage de températures d'un moteur de véhicule à démarrer par le système de stockage d'énergie électrique étant prise en compte pour l'interprétation des données de démarrage de moteur générées, et le résultat délivré en sortie de l'interprétation concernant une prédiction, en référence à la capacité du système de stockage d'énergie électrique, à pouvoir démarrer un moteur de véhicule d'une marque de véhicule déterminée, d'un modèle de véhicule déterminé et/ou d'une variante de véhicule déterminée en présence de différentes températures du moteur de véhicule ; et/ou
la capacité du système de stockage d'énergie électrique à pouvoir démarrer un moteur de véhicule d'une marque de véhicule déterminée, d'un modèle de véhicule déterminé et/ou d'une variante de véhicule déterminée étant une capacité du système de stockage d'énergie électrique à pouvoir démarrer à froid ou à chaud un moteur de véhicule de la marque de véhicule prise en compte lors de l'interprétation, du modèle de véhicule pris en compte lors de l'interprétation et/ou de la variante de véhicule prise en compte lors de l'interprétation.

14. Système selon la revendication 13,
le dispositif d'interprétation possédant un algorithme de prédiction de démarrage de moteur basé sur le principe de l'apprentissage automatique.

15. Système selon la revendication 13 ou 14,
le système possédant une interface de sortie destinée à délivrer en sortie un résultat de l'interprétation effectuée par le dispositif d'interprétation et le système étant configuré pour mettre en oeuvre le procédé selon l'une des revendications 1 à 13.
